(19) Europäisches Patentamt
European Patent Office
Office européen des brevets

(11) EP 0 461 879 B1

(12) EUROPEAN PATENT SPECIFICATION

(45) Date of publication and mention
of the grant of the patent:
29.05.1996 Bulletin 1996/22

(51) Int Cl.⁶: H01L 29/74, H01L 29/06,
H01L 21/332, H01L 21/76

(21) Application number: 91305303.9

(22) Date of filing: 12.06.1991

(54) **Semiconductor device having an isolating groove and method of making the same**

Halbleiteranordnung mit einem isolierenden Graben und Verfahren zu deren Herstellung

Dispositif semi-conducteur comportant un sillon d'isolation et méthode de fabrication

(84) Designated Contracting States:
DE ES FR GB

(30) Priority: 12.06.1990 JP 154621/90

(43) Date of publication of application:
18.12.1991 Bulletin 1991/51

(73) Proprietor: MITSUBISHI DENKI KABUSHIKI
KAISHA
Tokyo (JP)

(72) Inventor: Tokunoh, Futoshi,
c/o Mitsubishi Denki K.K.
Nishi-ku, Fukuoka-shi, Fukuoka (JP)

(74) Representative: Hackett, Sean James et al
MARKS & CLERK,
57-60 Lincoln's Inn Fields
London WC2A 3LS (GB)

(56) References cited:
EP-A- 0 164 645          EP-A- 0 200 863
EP-A- 0 286 855          DE-A- 3 521 079

• PATENT ABSTRACTS OF JAPAN vol. 6, no. 251
(E-147)(1129) 10 December 1982& JP-A-57 148
371
• INTERNATIONAL ELECTRON DEVICES
MEETING 1981 - TECHNICAL DIGEST December
1981,WASHINGTON, D.C., USA pages 410 - 413
JOHN X. PRZYBYSZ AND EARL S.
SCHLEGEL'THYRISTORS WITH
OVERVOLTAGE SELF-PROTECTION'
• EPE'89 3RD EUROPEAN CONFERENCE ON
POWER ELECTRONICS AND APPLICATIONS
October1989, AACHEN, GERMANY pages 121 -
125 M. ISHIDOH ET AL. 'A NEW
REVERSECONDUCTING GTO'
• IBM TECHNICAL DISCLOSURE BULLETIN. vol.
31, no. 7, December 1988, NEW YORK USpages
420 - 422 'ACCELERATED ETCHING OF SILICON
IN ANISOTROPIC
ETHYLENEDIAMINE-WATER-PYRAZINE-PYRO
CATHEOL BATH'

**Description**

BACKGROUND OF THE INVENTION

Field of the Invention

The present invention relates to a semiconductor device and a manufacturing method thereof and more particularly to an improvement on a groove structure used for resistive isolation between elements.

Description of the Prior Art

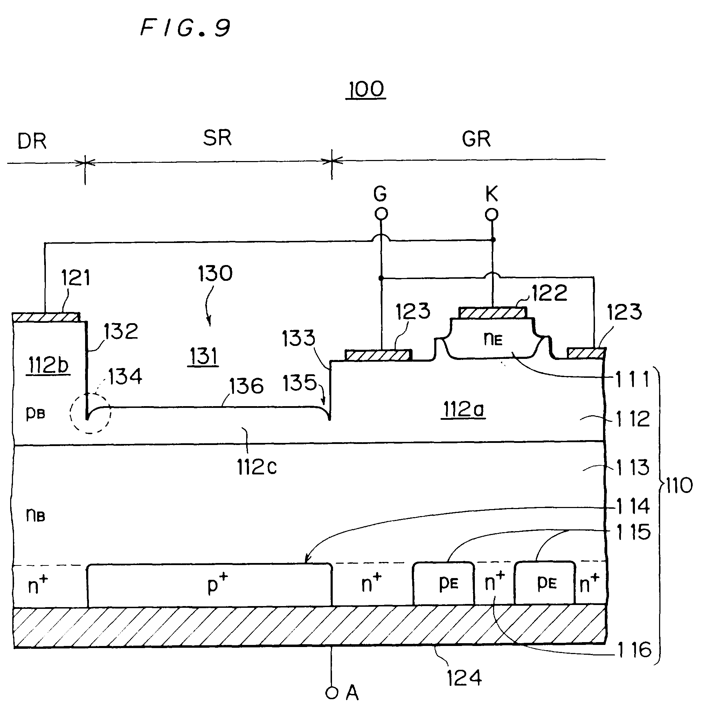

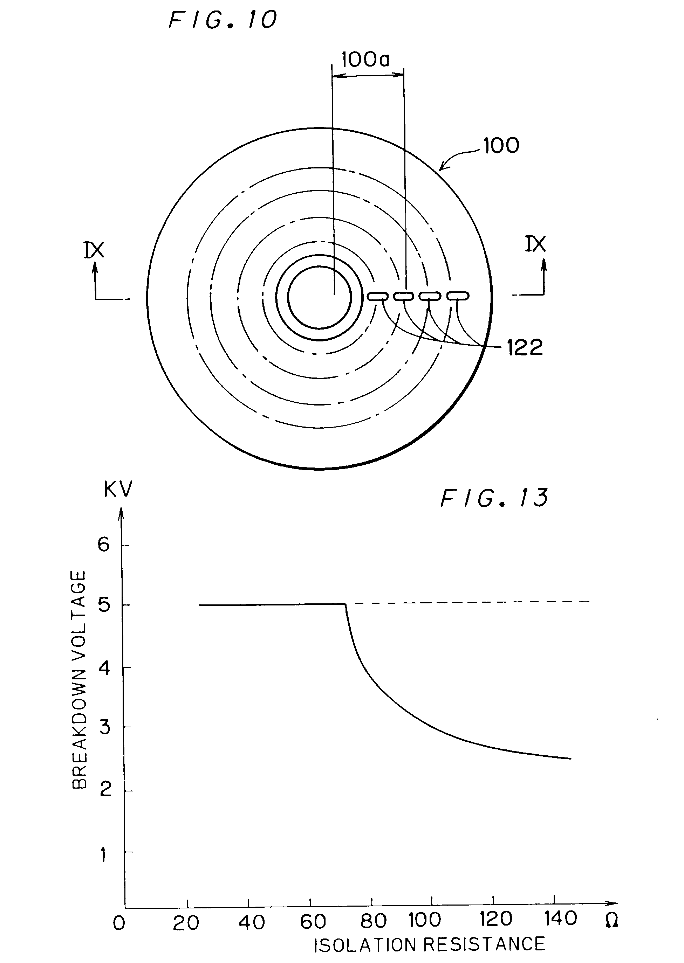

Fig. 9 is a partial cross-sectional view showing the structure of a conventional reverse-conducting gate turn-off thyristor (reverse-conducting GTO) 100 in the vicinity of an element isolation region. Fig. 9 corresponds to a cross section of a part 100a of the reverse-conducting GTO 100 taken along the line IX-IX of Fig. 10 which is a plan view thereof.

The reverse-conducting GTO 100 comprises a semiconductor body 110, which has a pnpn four-layer structure consisting of an n emitter layer 111 ($n_E$), a p base layer 112 ($p_B$), an n base layer 113 ($n_B$) and p emitter layers 115 ($p_E$). Although Fig. 9 shows a single n emitter layer 111, a large number of n emitter layers 111 are formed on the p base layer 112. Between the respective p emitter layers 115 is provided an n-type high impurity concentration region 116 ($n^+$).

The semiconductor body 110 incorporates a GTO and a diode in reverse parallel. A region GR is a GTO region, which is connected to an external circuit through a cathode layer 122 (K), gate electrode layers 123 (G) and an anode layer 124 (A). A region DR is a diode region, in which an electrode layer 121 is used as an anode of the diode and the electrode layer 124 functions also as a cathode of the diode. The electrode layer 121 is electrically connected to the cathode layer 122.

An element isolation region SR is provided between the GTO region GR and the diode region DR. In the element isolation region SR is formed an element isolation structure 130 having an isolating groove 131. The isolating groove 131 is formed by selectively etching the p base layer 112. Overetched portions 134 and 135 are formed at the foot of sidewalls 132 and 133 of the isolating groove 131. A $p^+$ isolation layer 114 is formed selectively in the part of the n base layer 113 under the isolating groove 131.

A p region 112c which is the part of the p base layer 112 at the bottom of the isolating groove 131 has a function of resistively separating the p layer 112 into a part 112a in the GTO region GR and a part 112b in the diode region DR by sheet resistivity thereof. That is, since isolation resistance by the sheet resistivity of the p region 112c is inserted equivalently between the electrode layers 121 and 123, a leakage current between the gate and the cathode through the p region 112c can be reduced.

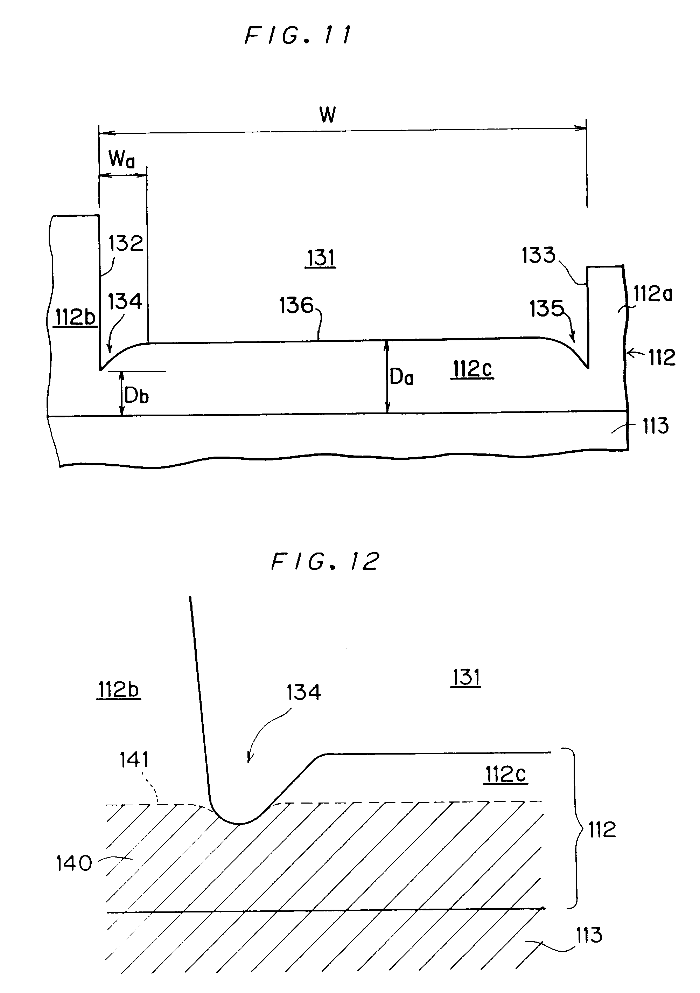

Fig. 11 is an enlarged view of the isolating groove 131. Under the same diffusion conditions and the like, the sheet resistivity of the p region 112c generally depends on the thickness of the p region 112c. The center of the bottom 136 of the isolating groove 131 is different from the overetched portions 134 and 135 in thickness of the p region 112c. The width $W_a$ of the respective overetched portions 134 and 135 is quite smaller than the overall width W of the isolating groove 131. Therefore the isolation resistance of the reverse-conducting GTO 100 by the region 112c is substantially determined by the thickness $D_a$ of the p region 112c in the center of the bottom 136 of the isolating groove 131. The smaller the thickness $D_a$ is, the higher isolation capability is.

When a forward voltage is applied to the GTO region GR, a depletion layer extends in the p layer 112. Fig. 12 shows typically the extension of the depletion layer in the vicinity of the overetched portion 134 enclosed by the broken line in Fig. 9. As the forward applied voltage increases, the extension quantity of the depletion layer 140 increases, so that the top 141 thereof approaches the overetched portion 134 to be exposed to the isolating groove 131. The influence of ions and the like adhering on the overetched portion 134 causes local electric field concentration on the top of the depletion layer 140, sometimes resulting in breakdown of the reverse-conducting GTO 100. For improving a forward breakdown voltage of the reverse-conducting GTO 100, the thickness $D_b$ (in Fig. 11) of the p region 112c at the deepest part of the overetched portions 134 and 135 should be large.

In the conventional reverse-conducting GTO 100, however, increase in the thickness $D_b$ inevitably results in increase in the thickness $D_a$ of the center because of a $D_b < D_a$ relation. There is a trade-off relation between the isolation resistance and the forward breakdown voltage, and it is difficult to improve both of them at the same time. Fig. 13 is a graph illustrating such a state, in which the forward breakdown voltage starts to drop when the isolation resistance exceeds about 70Ω. The broken line in Fig. 13 represents a theoretical value of the breakdown voltage of $P_B n_B$ junction.

EP-A-200863 describes a device which includes an isolation structure between a GTO and diode. The isolation structure has a two stage groove above the common pn junction, the depth of this groove increases step-wise towards the centre.

US 4 791 470 discloses a similar arrangement.

EP-A-286855 discloses the formulation of multistage grooves for passivation regions in power devices. It teaches a step-wise selective etching method.

## SUMMARY OF THE INVENTION

According to a first aspect of the present invention there is provided a semiconductor device as set out in Claim 1. Preferred features of this aspect of the invention are set out in Claims 2 to 5.

According to a second aspect of the present invention there is provided a method of manufacturing a semiconductor device as set out in Claim 6.

Preferred features ofthe second aspect ofthe invention are set out in Claims 7 to 13.

According to the semiconductor device of the present invention, resistive isolation between the elements is carried out by the use of the multistage groove having the depth increasing stepwise in series toward the center thereof. The depth of the multistage groove in the center can be increased-without increasing the depth thereof at the very ends. The isolation resistance can therefore be improved while a breakdown voltage is not decreased. Particularly by setting the width of the step structure in the inner wall portion of the multistage groove to 10% or more of the overall width of the multistage groove, the depth of the groove in the center can be sufficiently increased independently of the influence of the local shape of the multistage groove in the vicinity of the very ends.

According to the method of the present invention, the aforesaid multistage groove is provided through the repetition of etching. The depth of the multistage groove in the center can be increased without being restricted by the overetched depth of the multistage groove at the very ends.

As described hereinabove, according to the present invention, the resistive isolation between the elements is carried out by the use of the multistage groove, so that the depth of the groove in the center is determinable without the restriction by the depth thereof at the very ends. Therefore, a semiconductor device capable of increasing both isolation resistance and breakdown voltage can be achieved.

According to the present invention, since the depth of the groove in the center can be increased independently of the influence of the local shape of the multistage groove in the vicinity of the very ends, the isolation resistance and the breakdown voltage can be further improved.

According to the present invention, the aforesaid multistage groove is provided through the repetition of etching. The depth of the multistage groove in the center can be increased without being restricted by the overetched depth of the multistage groove at the very ends. Hence, a semiconductor device in which both the isolation resistance and the breakdown voltage are improved can be provided.

Therefore an object of the present invention is to provide a semiconductor device and a manufacturing method thereof capable of improving both isolation resistance and breakdown voltage.

These and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a partial cross-sectional view of a reverse-conducting GTO according to one preferred embodiment of the present invention;

Fig. 2A is an equivalent circuit diagram of the reverse-conducting GTO;

Fig. 2B is a plan view of the reverse-conducting GTO according to the preferred embodiment;

Figs. 3A - 3F are cross-sectional views showing manufacturing processes of the reverse-conducting GTO according to the preferred embodiment;

Figs. 4A and 4B are enlarged views of a multistage groove structure in manufacturing steps according to the preferred embodiment, respectively;

Fig. 5 is a characteristic explanatory view of a multistage groove according to the preferred embodiment;

Fig. 6 is a graph illustrating a relation between isolation resistance and forward breakdown voltage in the reverse-conducting GTO according to the preferred embodiment;

Figs. 7, 8A and 8B are partial views of the multistage groove structure according to another preferred embodiment of the present invention;

Fig. 9 is a partial cross-sectional view of a conventional reverse-conducting GTO;

Fig. 10 is a plan view of the conventional reverse-conducting GTO;

Fig. 11 is an enlarged view of a conventional resistive isolating groove;

Fig. 12 is a characteristic explanatory view of the conventional reverse-conducting GTO; and

Fig. 13 is a graph illustrating a relation between isolation resistance and forward breakdown voltage in the conventional reverse-conducting GTO.

## DESCRIPTION OF THE PREFERRED EMBODIMENTS

### A. Device Structure

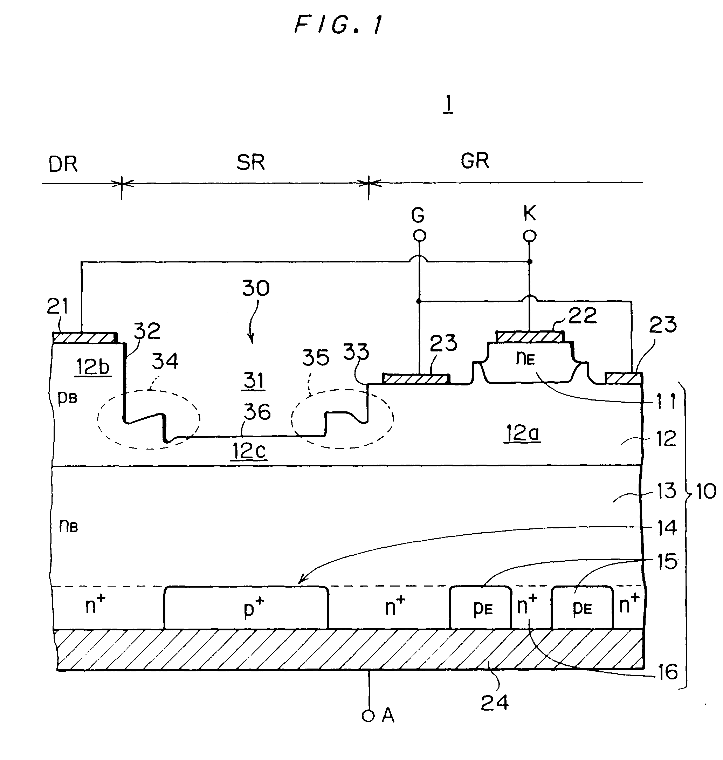

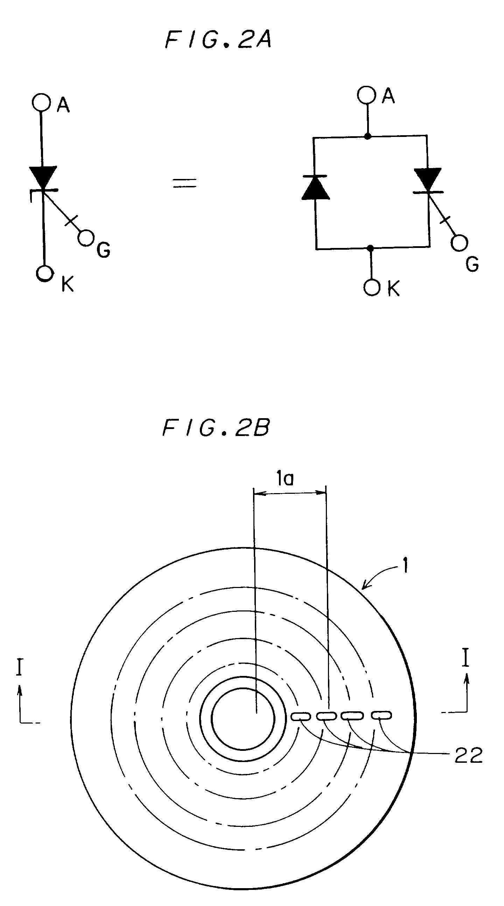

Fig. 1 is a partial cross-sectional view of a reverse-conducting GTO 1 according to one preferred embodiment of the present invention and corresponds to a cross section of a part 1a of the reverse-conducting GTO 1 taken along the line I-I of Fig. 2B which is a plan view thereof. The reverse-conducting GTO 1 corresponds to a reverse parallel connection between a GTO and a diode as shown in Fig. 2A.

As shown in Fig. 1, the reverse-conducting GTO 1 comprises a semiconductor body 10, in which a p base layer 12 ($p_B$) is formed on an n base layer 13 ($n_B$). An n emitter layer 11 is selectively provided on the p base layer 12. Although a single n emitter layer 11 is shown in Fig. 1, a large number of n emitter layers 11 are disposed on the semiconductor body 10. In lower portions of the n base layer 13 are selectively formed p emitter layers 15 ($p_E$). An n-type high impurity concentration region 16 ($n^+$) is provided between the respective p emitter layers 15.

The semiconductor body 10 is provided with three regions GR, DR and SR disposed in the direction parallel to a major surface thereof. The region GR constitutes a GTO and the region DR constitutes a diode. The region SR is an element isolation region used for the resistive isolation between the GTO region GR and the diode region DR, and is provided with an element isolation structure 30. The element isolation structure 30 has a multistage groove 31 formed in the p layer 12. The overall width of the multistage groove 31 is specified by sidewalls 32 and 33, and the depth thereof increases toward the center stepwise in series. Accordingly the width of the bottom 36 of the multistage groove 31 is smaller than the distance between the sidewalls 32 and 33, that is, the overall width of the multistage groove 31. The p layer 12 is divided into p regions 12a, 12b and 12c in accordance with the division by the regions GR, DR and SR. In a lower portion of the n base layer 13 is formed a p-type high impurity concentration region 14 ($p^+$) having a width corresponding to the bottom 36.

On the major bottom surface of the semiconductor body 10 is brazed an anode layer 24 composed of molybdenum. Cathode layers 22 are provided on the n emitter layers 11. Corresponding to the numerous n emitter layers 11, the cathode layers 22 are also arranged concentrically in great numbers (as shown in Fig. 2B). An anode layer 21 of the diode is formed on the p region 12b and is connected to the cathode layer 22 in common. Gate electrodes 23 are formed on the p region 12a. These electrode layers 21, 22 and 23 are composed of aluminium, for example.

The operational characteristics of the reverse-conducting GTO 1 depend on the shape of the multistage groove 31, however, the details of the shape can be understood through the forming processes of the multistage groove 31. Hereinafter described are the manufacturing processes of the reverse-conducting GTO 1 and subsequently the operational characteristics thereof.

### B. Manufacturing Processes

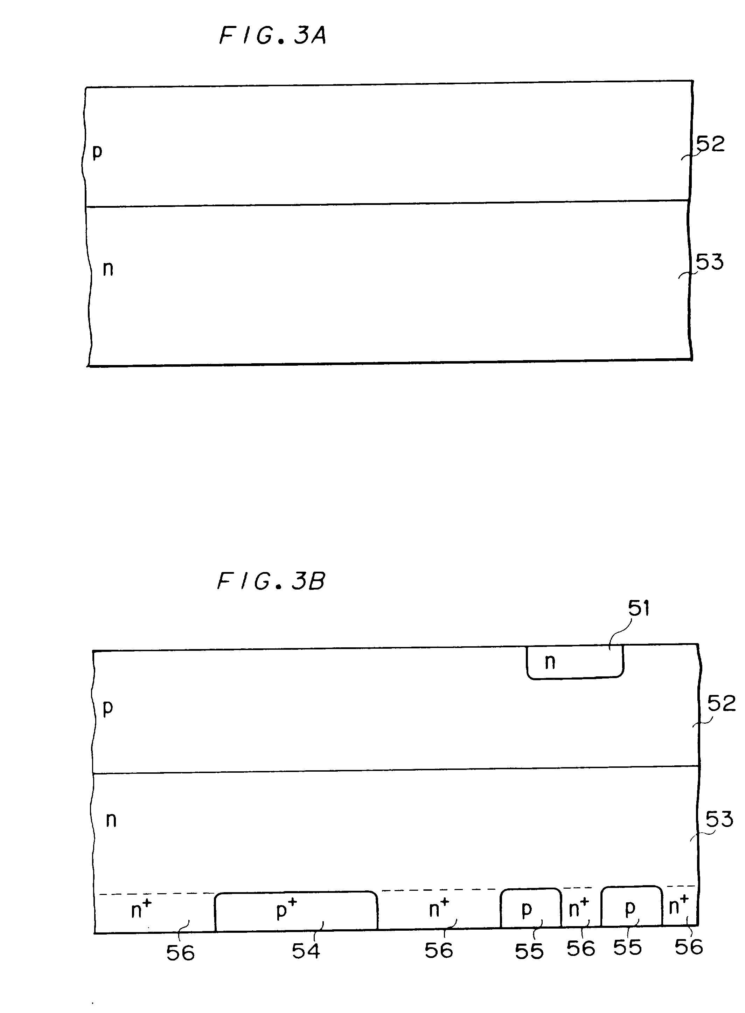

First prepared is a structure in which a p diffusion layer 52 is provided on the major top surface of an n-type semiconductor substrate 53 as shown in Fig. 3A. This structure is prepared, for example, in such a manner that p-type impurities are diffused on the both major surfaces of an n-type silicon wafer and a p diffusion layer on the major bottom surface side is removed by lap-off process.

Next, n-type impurities are selectively diffused on the major top surface of the p diffusion layer 52 to provide an n diffusion layer 51, as shown in Fig. 3B. After n-type impurities are diffused at high concentration on the major bottom surface of the n layer 53, p-type impurities are selectively diffused thereon to provide a $p^+$ layer 54, p layers 55 and $n^+$ layers 56. The n layer 51 may be formed after the layers 54 - 56 are formed.

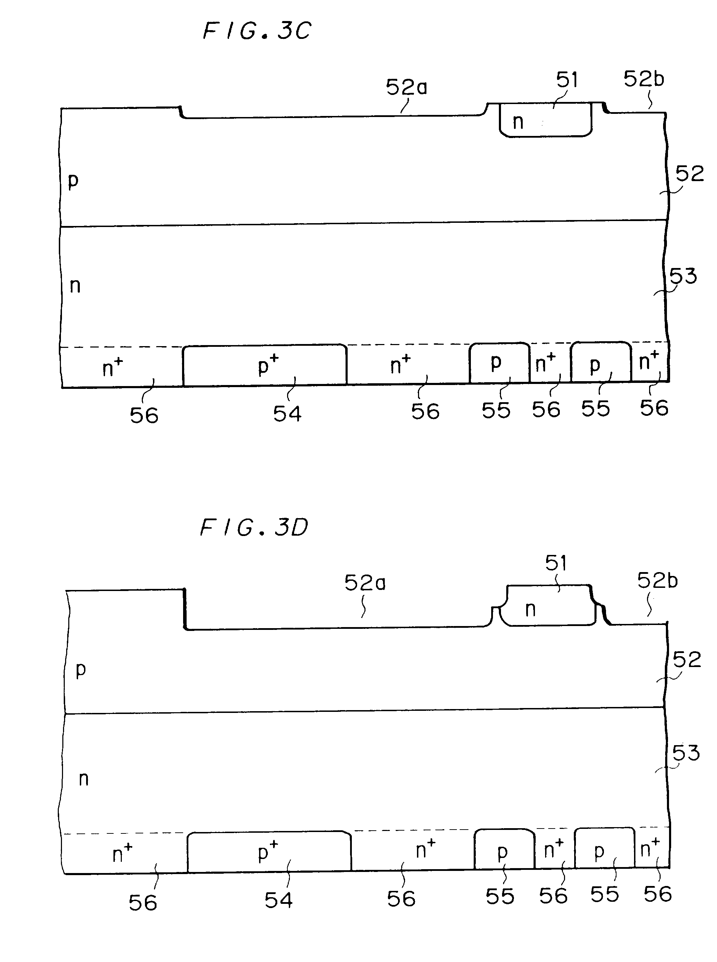

In the next step (in Fig. 3C), the top surface of the p diffusion layer 52 is selectively etched to form shallow concaves 52a and 52b. The area including the concaves 52a and 52b and the sides of the n diffusion layer 51 is further selectively etched, thereby the n diffusion layer 51 being formed into a mesa shape (in Fig. 3D).

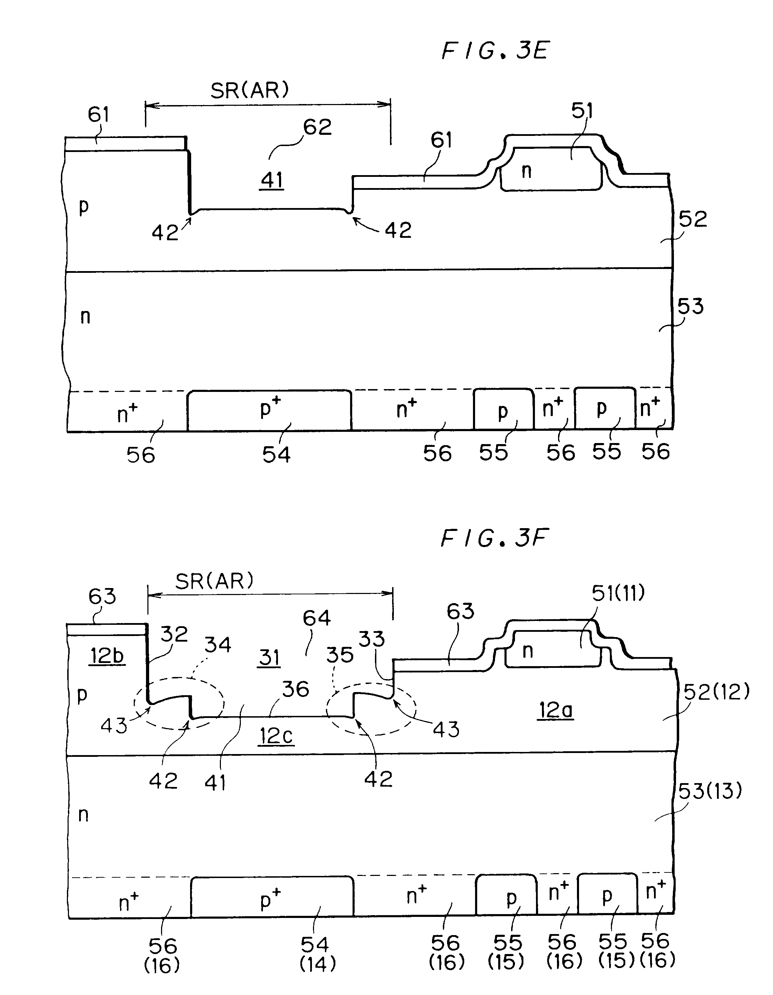

In the next step (in Fig. 3E), a silicon oxide film 61 is formed on the entire top surface of the structure of Fig. 3D and is patterned by means of photolithography. The patterned oxide film 61 has a window 62 in the center of an area AR to be formed into the element isolation regoin SR. The window 62 is narrower than the area AR. Masked with the oxide film 61, the p layer 52 is selectively etched to form a relatively shallow groove 41. The depth of the groove 41 is preferably about 15% or more of the depth of the multistage groove to be formed (whose numerical value example is described later). This etching is carried out by the use of a mixture of hydrofluoric acid and nitric acid or an etchant prepared by adding acetic acid to the mixture. This wet etching is referred to as "first etching" hereinafter. The first etching forms overetched portions 42 at both ends of the groove 41. Since the groove 41 is shallow, the overetched quantity is a little.

After the removal of the oxide film 61, a new silicon oxide film 63 (in Fig. 3F) is formed on the entire top surface.

The oxide film 63 is selectively removed by means of photolithography, thereby the oxide film 63 being patterned. The patterned oxide film 63 has a window 64 having the width substantially equal to that of the area AR. In the case where the oxide film 61 of Fig. 3E is formed relatively thick, the oxide film 63 may be obtained by removing the oxide film 61 selectively.

Next, masked with the oxide film 63, the top surface of the p layer 52 is selectively etched (second etching) by the use of the same etchant as described above. By the second etching, the depth of the groove 41 is increased on the whole, and part of the p layer 52 positioned outside the groove 41 is also removed. As a result, the multistage groove 31 having step structures 34 and 35 at both ends is obtained. Overetched portions 42 and 43 are found at the respective concave corners of the step structures 34 and 35. The overetched portions 43 are formed during the second etching. Subsequently, the oxide film 63 is removed, and the electrode layers 21 - 24 of Fig. 1 are formed so that the reverse-conducting GTO 1 is provided. The layers 51 - 56 of Fig. 3F correspond to the layers 11 - 16 of Fig. 1, respectively.

C. Detailed Shape and Operational Characteristic

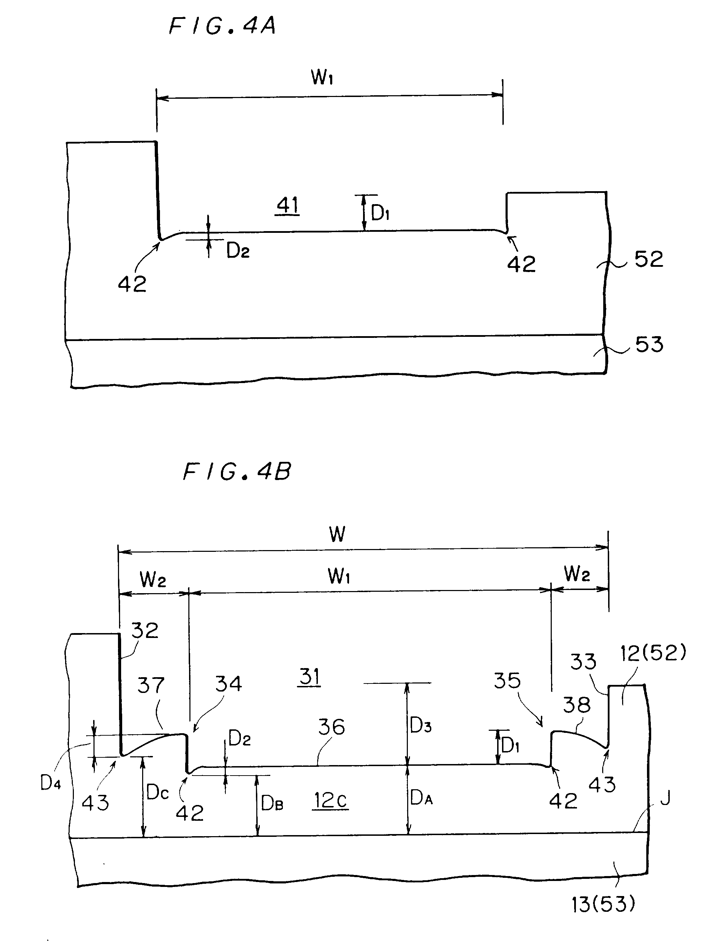

The detailed shape of the multistage groove 31 obtained by these manufacturing processes is described hereinafter. First in Fig. 4A showing the state when the first groove 41 is formed, the width $W_1$ of the groove 41 is, for example, 2.0nm. The depth $D_1$ of the groove 41 in the center is about 10µm. When a relation between the depth of the groove 41 and an overetched quantity $D_2$ is examined in the formation of the groove 41,

$$D_2 = k \cdot D_1 \tag{1}$$

can be found, where it has been confirmed that the proportional constant k ranges from 0.1 to 0.15. Therefore, the overetched quantity $D_2$ is about 1.0-1.5µm.

In Fig. 4B showing the state when the formation of the multistage groove 31 is finished, the overall width W of the multistage groove 31 is, for example, 3.0mm. The width of the step structures 34 and 35, that is, the width $W_2$ of each step surface 37 and 38 is as follows:

$$W_2 = (W-W_1)/2$$
$$= 0.5mm \tag{2}$$

In the case of carrying out the etching so that the depth $D_3$ of the multistage groove 31 is adapted to be 60µm, an overetched quantity $D_4$ at the overetched portions 43 is, for example, 6-9µm. With respect to a distance from the interface J of the p layer 12 and the n layer 13 to the bottom 36 of the multistage groove 31 in the center, that is, the thickness $D_A$ of the p region 12c in the center, distances $D_B$ and $D_C$ from the overetched portions 42 and 43 respectively to the interface J are in the following relations:

$$D_B = D_A - D_2$$
$$= D_A - 1.0µm \tag{3}$$
$$D_C = D_A + D_1 - D_4$$
$$= D_A + 10µm - 6µm$$
$$= D_A + 4µm \tag{4}$$

where 10µm, 1.0µm and 6µm are used as example values of $D_1$, $D_2$ and $D_4$, respectively.

What is found from the relations of the formulas (3) and (4) is described hereinafter. According to the formula (3), the bottom of the overetched portions 42 is deeper than that of the multistage groove 41 in the center, and the difference therebetween is about 1.0µm. The relation between the thicknesses $D_a$ and $D_b$ of the prior art (in Fig. 11) is, for example, as follows:

$$D_b = D_a - 6.0µm \tag{5}$$

From the comparison, it is found that the bottom 36 of the multistage groove 31 is substantially flat through the whole area and the overetched portions 42 are not so close to the interface J in the reverse-conducting GTO 1 according to the preferred embodiment. This is because the shape of the overetched portions 42 does not change substantially in the second etching so that the overetched quantity $D_2$ in the first etching is maintained.

The overetched portions 43 immediately under the sidewalls 32 and 33 of the multistage groove 31 are, as is obvious from the formula (4), considerably above the bottom 36. The influence of the overetched portions 43 on the electrical characteristics of the p region 12c can be practically disregarded.

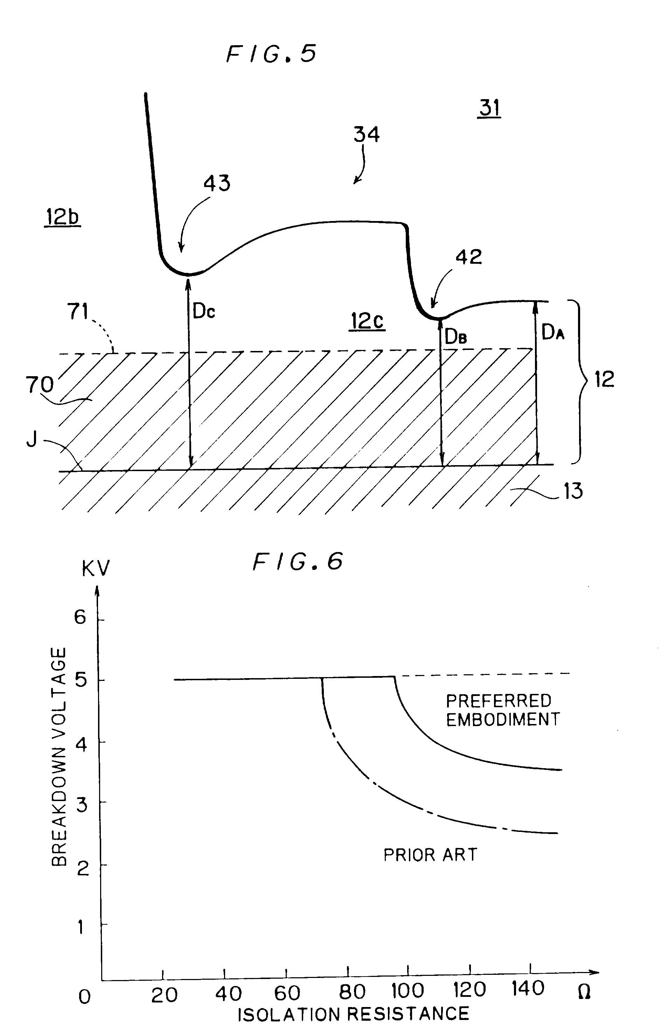

Fig. 5 is a typical enlarged view of the step structure 34. When a forward voltage is applied to the reverse-conducting GTO 1, a depletion layer 70 extends from the interface J of the p layer 12 and the n layer 13. The top 71 of the depletion layer 70 does not approach the overetched portions 42 easily. Even if the isolation resistance between the GTO and the diode is increased by decreasing the thickness $D_A$, the top 71 of the depletion layer 70 is not exposed to the surface of the p layer 12 easily. As a result, both the isolation resistance and the forward breakdown voltage can be improved. In other words, the forward breakdown voltage is remarkably improved when the value of the isolation resistance is the same as that of the prior art, and the value of the isolation resistance is remarkably improved when the forward breakdown voltage is the same as that of the prior art.

Fig. 6 is a graph illustrating such a relation. In the reverse-conducting GTO 1 of the preferred embodiment, the forward breakdown voltage does not drop even if the isolation resistance is improved up to approximately $100\Omega$. A higher breakdown voltage than the prior art can be ensured in the region in which the forward breakdown voltage starts to drop.

When the width $W_2$ (in Fig. 4B) of the respective step structures 34 and 35 is too small, the overetched portions 42 and 43 overlap each other partially, and resultingly the overetched portions 42 grow too deep. Hence the width $W_2$ is preferably not too small. In the case where a silicon wafer of 100mm in diameter is used for forming the reverse-conducting GTO 1 to be etched masked with a silicon oxide film, it has been confirmed that the lateral width of the overetched portions 43 is 50-10% of the overall width W of the area to be etched. Accordingly the width $W_2$ of the step structures 34 and 35 is preferably 10% or more of the width of the area AR, that is, the overall width W of the multistage groove 41. It can be easily confirmed that the width $W_2$=0.5mm in this preferred embodiment is larger than 10% of the area width W=3mm.

D. Other Preferred Embodiments

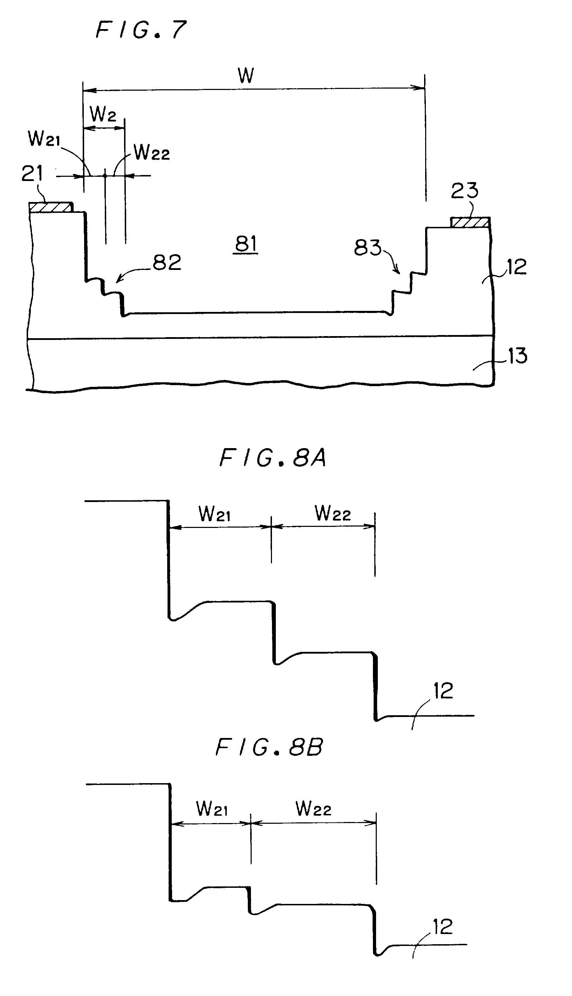

Fig. 7 shows a multistage groove 81 according to another preferred embodiment of he present invention. At both ends of the multistage groove 81 are provided step structures 82 and 83, each of which has a two-stage step structure. This type of two-stage step structure can be obtained through three etchings in which the etching width is in series expanded. The width $W_2$ of the step structures 82 and 83 is also preferably 10% or more of the overall width W of the isolating groove 81. A relation between separate widths $W_{21}$ and $W_{22}$ of the respective steps is arbitrary, whether the widths $W_{21}$ and $W_{22}$ are equal to each other as shown in Fig. 8A or different from each other as shown in Fig. 8B. A step structure having three steps or more is also useful.

The present invention can be applied to every type of semiconductor device which requires the resistive isolation between the elements. An example is a device including a reverse parallel connection between the thyristor and the diode other than the GTO, e.g., a reverse-conducting GATT (a reverse-conducting gate associated turn-off thyristor) and a photo thyristor having a main thyristor and an auxiliary thyristor.

**Claims**

1.  A semiconductor device (1) comprising:

    (a) a first power semiconductor element structure formed in a first (GR) region of a semiconductor body (10);
    (b) a second power semiconductor element structure formed at a distance from said first semiconductor element structure in the direction parallel to a major surface of said semiconductor body (10); and
    (c) a resistive isolation structure (30) provided between said first and second semiconductor element structures;

    wherein said element isolation structure (30) is provided with a multistage groove (31) formed on said major surface and having a depth increasing stepwise in series toward the center thereof so that said multistage groove (31) does not cut any pn junctions extending from said first semiconductor element structure to said second semiconductor element structure;
    characterized in that
    said multistage groove (31) has a step structure (34, 35) on an inner wall portion (32,33) of said multistage groove (31);
    the width of said step structure (34,35) is 10% or more of the overall width of said multistage groove (31);
    said multistage groove (31) has a bottom floor (36) whose edge portions (42) are deeper than the central portion of said bottom floor (36);
    said step structure (34,35) has a step surface (3 7,38) defined between a step edge and a step corner (43);
    said step corner (43) is located at a position lower than said step edge; and
    said position of step corner (43) is higher than a position at which said edge portion (42) of said bottom floor (36) is located.

2.  A semiconductor device (1) as set forth in claim 1, wherein
    a first distance in height between said position of step corner (43) and said position of said edge portion (42) is larger than a second distance in height ($D_2$) between said central portion of said bottom floor (36) and said edge portion (42) of said bottom floor (36).

3. A semiconductor device (1) as set forth in claim 2, wherein
said position of step corner (43) is higher than said position of said central portion of said bottom floor (36).

4. A semiconductor device (1) as set forth in claim 3, wherein
said second difference ($D_2$) is in the range from 1.0 $\mu$m to 1.5 $\mu$m.

5. A semiconductor device (1) as set forth in claim 3, wherein

said semiconductor body (10) is provided therein with a pn junction structure having a pn junction interface extending in parallel to said major surface of said semiconductor body (10);
said pn junction structure (12,13) has first through third portions aligned in parallel to said major surface of said semiconductor body (10);
said first and third portions of said pn junctions structure (12,13) are located in said first and second regions of said semiconductor body (10) and are members of said first and second semiconductor element structures, respectively; and
said second portion of said pn junction structure (12,13) is located between said first and second regions of said semiconductor body (10), and exposed to said multistage groove (31).

6. A method of manufacturing a semiconductor device (1), comprising the steps of:

(a) forming in a semiconductor body (10) first and second power semiconductor element structures disposed with a predetermined area therebetween in a direction parallel to a major surface of said semiconductor body (10);
(b) selectively etching a part of said major surface of said semiconductor body (10) located in said area to form a groove (41) having a predetermined width within said area; and
(c) selectively etching said major surface of said semiconductor body (10) in a range including said groove (31) and wider than said groove to form a multistage groove (31) having a depth increasing stepwise in series toward the center thereof so that said multistage groove (31) does not cut any pn junctions extending from said first semiconductor element structure to said second semiconductor element structure;

characterized in that
said step (c) comprises the step of:
(c-1) selectively etching said major surface of said semiconductor body (10) so as to satisfy predetermined conditions;
said predetermined conditions include:
a first condition that a step structure (34,35) having a width of 10% or more of the overall width of said multistage groove (31) is formed in an inner wall portion of said multistage groove (31);
said predetermined conditions further include:
a second condition that said multistage groove (31) has a bottom floor (36) whose edge portions (42) are deeper than the central portion of said bottom floor (36);
said predetermined conditions further include:
a third condition that said step structure (34,35) has a step surface (37,38) defined between a step edge and a step corner (43);
said predetermined conditions further include:
a fourth condition that said step corner (43) is located at a position lower than said step edge; and
said predetermined conditions further include:
a fifth condition that said position of step corner (43) is higher than a position at which said edge portion (42) of said bottom floor (36) is located.

7. A method as set forth in claim 6, wherein said predetermined conditions further include:
a sixth condition that a first distance in height between said position of step corner (43) and said position of said edge portion (42) is larger than a second distance in height ($D_2$) between said central portion of said bottom floor (36) and said edge portion (42) of said bottom floor (36).

8. A method as set forth in claim 7, wherein said predetermined conditions further include:
a seventh condition that said position of step corner (43) is higher than said position of said central portion of said bottom floor (36).

**9.** A method as set forth in claim 8, wherein said second difference is in the range from 1.0 μm to 1.5 μm.

**10.** A method as set forth in claim 9, wherein said step (b) comprises the step of
(b-1) selectively etching said part of said major surface of said semiconductor body (10) located in said area so that said groove (41) has a depth which is 15% or more of the depth of said bottom floor (36) of said multistage groove (31).

**11.** A method as set forth in claim 10, wherein said step (b-1) comprises the steps of:

(b-1-1) forming a first mask layer (61) on said major surface of said semiconductor (10);
(b-1-2) selectively removing said first mask layer (61) to obtain a first mask pattern having a first window having a size smaller than said area;
(b-1-3) selectively etching said part of said major surface of said semiconductor body through said first window; and
(b-1-4) removing said first mask pattern (61).

**12.** A method as set forth in claim 11, wherein said step (c-l) comprises the steps of:

(c-1-1) forming a second mask layer (63) on said major surface of said semiconductor body (10);
(c-1-2) selectively removing said second mask layer to obtain a second mask pattern having a second window adapted to said area;
(c-1-3) selectively etching said part of said major surface of said semiconductor body (10) through said second window; and
(c-1-4) removing said second mask pattern (63).

**13.** A method as set forth in claim 10, wherein said step (b-1) comprises the steps of:

(b-1-1) forming a first mask layer (61) on said major surface of said semiconductor body (10);
(b-1-2) selectively removing said first mask layer (61) to obtain a first mask pattern having a first window having a size smaller than said area; and
(b-1-3) selectively etching said part of said major surface of said semiconductor body (10) through said first window; and

said step (c-1) comprises the steps of:

(c-1-1) selectively removing said first mask pattern (61) to obtain a second mask pattern (63) having a second window adapted to said area;
(c-1-3) selectively etching said part of said major surface of said semiconductor body through said second window; and
(c-1-4) removing said second mask pattern (63).

**Patentansprüche**

**1.** Halbleitervorrichtung (1), die aufweist:

(a) eine erste Leistungshalbleiterelementstruktur, die in einem ersten (GR) Bereich eines Halbleiterkörpers (10) ausgebildet ist;
(b) eine zweite Leistungshalbleiterelementstruktur, die in einem Abstand von der ersten Halbleiterelementstruktur in der zu einer Hauptoberfläche des Halbleiterkörpers (10) parallelen Richtung ausgebildet ist; und
(c) eine widerstandsbehaftete Isolationsstruktur (30), die zwischen den ersten und zweiten Halbleiterelementstrukturen vorgesehen ist;

bei der die Elementisolationsstruktur (30) mit einer Mehrstufenrille (31) versehen ist, die auf der Hauptoberfläche ausgebildet ist und eine Tiefe aufweist, die sich stufenweise aufeinanderfolgend zu ihrer Mitte hin so erhöht, daß die Mehrstufenrille (31) keinen einzigen der pn-Übergänge schneidet, die sich von der ersten Halbleiterelementstruktur zu der zweiten Halbleiterelementstruktur erstrecken;

dadurch gekennzeichnet, daß

die Mehrstufenrille (31) eine Stufenstruktur (34, 35) auf einem Innenwandabschnitt (32, 33) der Mehrstufenrille (31) aufweist;

die Breite der Stufenstruktur (34, 35) 10% oder mehr der Gesamtbreite der Mehrstufenrille (31) beträgt;

die Mehrstufenrille (31) einen Unterboden (36) aufweist, dessen Kantenabschnitte (42) tiefer als der Mittenabschnitt des Unterbodens (36) sind;

die Stufenstruktur (34, 35) eine Stufenoberfläche (37, 38) aufweist, die zwischen einer Stufenkante und einer Stufenecke (43) definiert ist;

die Stufenecke (43) an einer Position angeordnet ist, die niedriger als die Stufenkante ist; und

die Position der Stufenecke (43) höher als eine Position ist, an welcher der Kantenabschnitt (42) des Unterbodens (36) angeordnet ist.

2. Halbleitervorrichtung (1) nach Anspruch 1, bei der

ein erster Abstand in der Höhe zwischen der Position der Stufenecke (43) und der Position des Kantenabschnitts (42) größer als ein zweiter Abstand in der Höhe ($D_2$) zwischen dem Mittenabschnitt des Unterbodens (36) und dem Kantenabschnitt (42) des Unterbodens (36) ist.

3. Halbleitervorrichtung (1) nach Anspruch 2, bei der

die Position der Stufenecke (43) höher als die Position des Mittenabschnitts des Unterbodens (36) ist.

4. Halbleitervorrichtung (1) nach Anspruch 3, bei der

sich die zweite Differenz ($D_2$) in dem Bereich von 1.0 µm bis 1.5 µm befindet.

5. Halbleitervorrichtung (1) nach Anspruch 3, bei der

der Halbleiterkörper (10) mit einer pn-Übergangsstruktur darin versehen ist, die eine pn-Übergangsschnittstelle aufweist, die sich parallel zu der Hauptoberfläche des Halbleiterkörpers (10) erstreckt;

die pn-Übergangsstruktur (12, 13) erste bis dritte Abschnitte aufweist, die parallel zu der Hauptoberfläche des Halbleiterkörpers (10) ausgerichtet sind;

die ersten und dritten Abschnitte der pn-Übergangsstruktur (12, 13) in den ersten und zweiten Bereichen des Halbleiterkörpers (10) angeordnet sind und Bestandteile der ersten bzw. zweiten Halbleiterelementstrukturen sind; und

der zweite Abschnitt der pn-Übergangsstruktur (12, 13) zwischen den ersten und zweiten Bereichen des Halbleiterkörpers (10) angeordnet ist und an der Mehrfachrille (31) freiliegt.

6. Verfahren zum Herstellen einer Halbleitervorrichtung (1), das die Schritte aufweist:

(a) Ausbilden erster und zweiter Leistungshalbleiterelementstrukturen, die mit einer vorbestimmten Fläche dazwischen in einer zu einer Hauptoberfläche eines Halbleiterkörpers (10) parallelen Richtung angeordnet sind, in dem Halbleiterkörper (10);

(b) selektives Ätzen eines Teils der Hauptoberfläche des Halbleiterkörpers (10), der in der Fläche angeordnet ist, um eine Rille (41), die eine vorbestimmte Breite aufweist, in der Fläche auszubilden; und

(c) selektives Ätzen der Hauptoberfläche des Halbleiterkörpers (10) in einem Bereich, der die Rille (31) beinhaltet und breiter als die Rille ist, um eine Mehrstufenrille (31) auszubilden, die eine Tiefe aufweist, die sich stufenweise aufeinanderfolgend zu ihrer Mitte hin so erhöht, daß die Mehrstufenrille (31) keinen einzigen der pn-Übergänge schneidet, die sich von der ersten Halbleiterelementstruktur zu der zweiten Halbleiterelementstruktur erstrecken;

dadurch gekennzeichnet, daß

der Schritt (c) den Schritt aufweist:

(c-1) selektives Ätzen der Hauptoberfläche des Halbleiterkörpers (10), um vorbestimmte Bedingungen zu erfüllen;

wobei die vorbestimmten Bedingungen beinhalten:

eine erste Bedingung, daß eine Stufenstruktur (34, 35), die eine Breite von 10% oder mehr der Gesamtbreite der Mehrstufenrille (31) aufweist, in einem Innenwandabschnitt der Mehrstufenrille (31) ausgebildet wird;

wobei die vorbestimmten Bedingungen des weiteren beinhalten:

eine zweite Bedingung, daß die Mehrstufenrille (31) einen Unterboden (36) aufweist, dessen Kantenabschnitte (42) tiefer als der Mittenabschnitt des Unterbodens (36) sind;

wobei die vorbestimmten Bedingungen des weiteren beinhalten:

eine dritte Bedingung, daß die Stufenstruktur (34, 35) eine Stufenoberfläche (37, 38) aufweist, die zwischen einer Stufenkante und einer Stufenecke (43) definiert ist;

wobei die vorbestimmten Bedingungen des weiteren beinhalten:

eine vierte Bedingung, daß die Stufenecke (43) an einer Position angeordnet ist, die niedriger als die Stufenkante ist; und

wobei die vorbestimmten Bedingungen des weiteren beinhalten:

eine fünfte Bedingung, daß die Position der Stufenecke (43) höher als eine Position ist, an welcher der Kantenabschnitt (42) des Unterbodens (36) angeordnet ist.

7.  Verfahren nach Anspruch 6, bei dem die vorbestimmten Bedingungen des weiteren beinhalten:

eine sechste Bedingung, daß ein erster Abstand in der Höhe zwischen der Position der Stufenecke (43) und der Position des Kantenabschnitts (42) größer als ein zweiter Abstand in der Höhe ($D_2$) zwischen dem Mittenabschnitt des Unterbodens (36) und dem Kantenabschnitt (42) des Unterbodens (36) ist.

8.  Verfahren nach Anspruch 7, bei dem die vorbestimmten Bedingungen des weiteren beinhalten:

eine siebte Bedingung, daß die Position der Stufenecke (43) höher als die Position des Mittenabschnitts des Unterbodens (36) ist.

9.  Verfahren nach Anspruch 8, bei dem sich die zweite Differenz in dem Bereich von 1.0 µm bis 1.5 µm befindet.

10.  Verfahren nach Anspruch 9, bei dem der Schritt (b) den Schritt aufweist:

(b-1) derartiges selektives Ätzen des Teils der Hauptoberfläche des Halbleiterkörpers (10), der in der Fläche angeordnet ist, daß die Rille (41) eine Tiefe aufweist, welche 15% oder mehr der Tiefe des Unterbodens (36) der Mehrfachrille (31) beträgt.

11.  Verfahren nach Anspruch 10, bei dem der Schritt (b-1) die Schritte aufweist:

(b-1-1) Ausbilden einer ersten Maskenschicht (61) auf der Hauptoberfläche des Halbleiters (10);
(b-1-2) selektives Entfernen der ersten Maskenschicht (61), um ein erstes Maskenmuster zu erzielen, das ein erstes Fenster aufweist, das eine Größe aufweist, die kleiner als die Fläche ist;
(b-1-3) selektives Ätzen des Teils der Hauptoberfläche des Halbleiterkörpers durch das erste Fenster; und
(b-1-4) Entfernen des ersten Maskenmusters (61).

12.  Verfahren nach Anspruch 11, bei dem der Schritt (c-1) die Schritte aufweist:

(c-1-1) Ausbilden einer zweiten Maskenschicht (63) auf der Hauptoberfläche des Halbleiterkörpers (10);
(c-1-2) selektives Entfernen der zweiten Maskenschicht, um ein zweites Maskenmuster zu erzielen, das ein zweites Fenster aufweist, das an die Fläche angepaßt ist;
(c-1-3) selektives Ätzen des Teils der Hauptoberfläche des Halbleiterkörpers (10) durch das zweite Fenster; und
(c-1-4) Entfernen des zweitenMaskenmusters(63).

13.  Verfahren nach Anspruch 10, bei dem der Schritt (b-1) die Schritte aufweist:

(b-1-1) Ausbilden einer ersten Maskenschicht (61) auf der Hauptoberfläche des Halbleiterkörpers (10);
(b-1-2) selektives Entfernen der ersten Maskenschicht (61), um ein erstes Maskenmuster zu erzielen, das ein erstes Fenster aufweist, das eine Größe aufweist, die kleiner als die Fläche ist; und
(b-1-3) selektives Ätzen des Teils der Hauptoberfläche des Halbleiterkörpers (10) durch das erste Fenster; und

der Schritt (c-1) die Schritte aufweist:

(c-1-1) selektives Entfernen des ersten Maskenmusters (61), um ein zweites Maskenmuster (63) zu erzielen, das ein zweites Fenster aufweist, das an die Fläche angepaßt ist;
(c-1-3) selektives Ätzen des Teils der Hauptoberfläche des Halbleiterkörpers durch das zweite Fenster; und
(c-1-4) Entfernen des zweiten Maskenmusters (63).

**Revendications**

1. Dispositif semi-conducteur (1) comprenant :

   (a) une première structure d'un élément semi-conducteur de puissance formée dans une première région (GR) d'un corps semi-conducteur (10);
   (b) une seconde structure d'un élément semi-conducteur de puissance formée à une distance de ladite première structure d'élément semi-conducteur en direction parallèle à la surface majeure du corps semi-conducteur (10); et
   (c) une structure d'isolement résistif (30) prévue entre lesdites première et seconde structures d'éléments semi-conducteurs;

   où ladite structure d'isolement des éléments (30) est pourvue d'un sillon (31) à plusieurs étages qui est formé sur ladite surface majeure et dont la profondeur augmente de manière échelonnée en série vers son centre de manière que ledit sillon (31) à plusieurs étages ne coupe aucune jonction pn s'étendant de ladite première structure de l'élément semi-conducteur jusqu'à ladite seconde structure de l'élément semi-conducteur;
   caractérisé en ce que
   ledit sillon (31) à plusieurs étages a une structure échelonnée (34, 35) sur une portion de paroi interne (32, 33) dudit sillon (31) à plusieurs étages;
   la largeur de ladite structure échelonnée (34, 35) est de 10% ou plus de la largeur totale dudit sillon à plusieurs étages (31);
   ledit sillon à plusieurs étages (31) a un fond (36) dont les portions (42) des bords sont plus profondes que la portion centrale dudit fond (36);
   ladite structure échelonnée (34, 35) a une surface échelonnée (37, 38) définie entre un bord d'échelon et un coin d'échelon (43);
   ledit coin d'échelon (43) est placé en une position plus basse que ledit bord d'échelon; et
   ladite position dudit coin d'échelon (43) est plus haute qu'une position à laquelle la portion (42) du bord dudit fond (36) est placée.

2. Dispositif semi-conducteur selon la revendication 1, où
   une première distance en hauteur entre ladite position du coin d'échelon (43) et ladite position de la portion de bord (42) est plus grande qu'une seconde distance en hauteur (D$_2$) entre ladite portion centrale dudit fond (36) et ladite portion de bord (42) dudit fond (36).

3. Dispositif semi-conducteur (1) selon la revendication 2, où
   ladite position dudit coin d'échelon (43) est plus haute que ladite position de ladite portion centrale dudit fond (36).

4. Dispositif semi-conducteur (1) selon la revendication 3, où
   ladite seconde différence (D$_2$) est comprise entre 1,0 μm et 1,5 μm.

5. Dispositif semi-conducteur (1) selon la revendication 3, où

   ledit corps semi-conducteur (10) est pourvu d'une structure à jonction pn ayant une interface de jonction pn s'étendant parallèlement à ladite surface majeure dudit corps semi-conducteur (10);
   ladite structure à jonction pn (12, 13) a des première à troisième portions alignées parallèlement à ladite surface majeure dudit corps semi-conducteur (10);
   lesdites première et troisième portions de ladite structure à jonction pn (12, 13) sont placées dans lesdites première et seconde régions dudit corps semi-conducteur (10) et sont des membres desdites première et seconde structures d'éléments semi-conducteurs, respectivement; et
   ladite seconde portion de ladite structure à jonction pn (12, 13) est placée entre lesdites première et seconde régions dudit corps semi-conducteur (10), et exposée audit sillon (31) à plusieurs étages.

6. Méthode de fabrication d'un dispositif semi-conducteur (1), comprenant les étapes de :

   (a) former, dans un corps semi-conducteur (10), des première et seconde structures d'éléments semi-conducteurs de puissance disposées avec une zone prédéterminée entre elles dans une direction parallèle à une surface majeure dudit corps semi-conducteur (10);

EP 0 461 879 B1

(b) attaquer sélectivement une partie de ladite surface majeure dudit corps semi-conducteur (10) qui se trouve dans ladite zone pour former un sillon (41) ayant une largeur prédéterminée dans ladite zone; et

(c) attaquer sélectivement ladite surface majeure dudit corps semi-conducteur (10) dans une gamme comprenant ledit sillon (31) et plus large que ledit sillon pour former un sillon (31) à plusieurs étages ayant une profondeur augmentant de façon échelonnée en série vers son centre de manière que ledit sillon (31) à plusieurs étages ne coupe aucune jonction pn s'étendant de ladite première structure d'élément semi-conducteur jusqu'à ladite seconde structure d'élément semi-conducteur;

caractérisée en ce que

ladite étape (c) comprend l'étape de :

(c-1) attaquer sélectivement ladite surface majeure dudit corps semi-conducteur (10) afin de satisfaire des conditions prédéterminées;

lesdites conditions prédéterminées comprennent :

une première condition selon laquelle une structure échelonnée (34, 35) ayant une large de 10% ou plus de la largeur totale dudit sillon (31) à plusieurs étages est formée dans une portion de paroi interne dudit sillon à plusieurs étages (31);

lesdites conditions prédéterminées comprennent de plus:

une seconde condition selon laquelle ledit sillon (31)

à plusieurs étages a un fond (36) dont les portions des bords (42) sont plus profondes que la portion centrale dudit fond (36);

lesdites conditions prédéterminées comprennent de plus :

une troisième condition selon laquelle ladite structure échelonnée (34, 35) a une surface d'échelon (37, 38) définie entre un bord d'échelon et un coin d'échelon (43);

lesdites conditions prédéterminées comprennent de plus:

une quatrième condition selon laquelle ledit coin d'échelon (43) est placé en une position plus basse que ledit bord d'échelon; et

lesdites conditions prédéterminées comprennent de plus :

une cinquième condition selon laquelle ladite position du coin d'échelon (43) est plus haute qu'une position à laquelle ladite portion de bord (42) dudit fond (36) est placée.

7. Méthode selon la revendication 6, où lesdites conditions prédéterminées comprennent de plus :
une sixième condition selon laquelle une première distance en hauteur entre ladite position dudit coin (43) d'échelon et ladite position de ladite portion de bord (42) est plus grande qu'une seconde distance en hauteur ($D_2$) entre ladite portion centrale dudit fond (36) et ladite portion du bord (42) dudit fond (36).

8. Méthode selon la revendication 7, où lesdites conditions prédéterminées comprennent de plus :
une septième condition selon laquelle ladite position du coin d'échelon (43) est plus haute que ladite position de ladite portion centrale dudit plancher (36).

9. Méthode selon la revendication 8, où ladite seconde différence est comprise entre 1,0 $\mu$m et 1,5 $\mu$m.

10. Méthode selon la revendication 9, où ladite étape (b) comprend l'étape de :
(b-1) attaquer sélectivement ladite partie de ladite surface majeure dudit corps semi-conducteur (10) qui se trouve dans ladite zone de manière que ledit sillon (41) ait une profondeur qui est de 15% ou plus de la profondeur dudit fond (36) dudit sillon (31) à plusieurs étages.

11. Méthode selon la revendication 10, où ladite étape (b-1) comprend les étapes de :

(b-1-1) former une première couche formant masque (61) sur ladite surface majeure dudit semi-conducteur (10);

(b-1-2) éliminer sélectivement ladite première couche formant masque (61) pour obtenir un premier masque ayant une première fenêtre ayant une grandeur plus petite que ladite zone;

(b-1-3) attaquer sélectivement ladite partie de ladite surface majeure dudit corps semi-conducteur par ladite première fenêtre, et

(b-1-4) éliminer ledit premier motif de masque (61).

12. Méthode selon la revendication 11, où ladite étape (c-1) comprend les étapes de :

(c-1-1) former une seconde couche formant masque (63) sur ladite surface majeure dudit corps semi-conducteur (10);

(c-1-2) éliminer sélectivement ladite seconde couche formant masque pour obtenir un second motif de masque ayant une seconde fenêtre adaptée à ladite zone;

(c-1-3) attaquer sélectivement ladite partie de ladite surface majeure dudit corps semi-conducteur (10) par ladite seconde fenêtre; et

(c-1-4) éliminer ledit second motif formant masque (63).

**13.** Méthode selon la revendication 10, où l'étape (b-1) comprend les étapes de :

(b-1-1) former une première couche formant masque (61) sur ladite surface majeure dudit corps semi-conducteur (10);

(b-1-2) éliminer sélectivement ladite première couche formant masque (61) pour obtenir un premier motif de masque ayant une première fenêtre d'une grandeur plus petite que ladite zone; et

(b-1-3) attaquer sélectivement ladite partie de ladite surface majeure dudit corps semi-conducteur (10) à travers ladite première fenêtre; et

ladite étape (c-1) comprend les étapes de :

(c-1-1) éliminer sélectivement ledit premier motif formant masque (61) pour obtenir un second motif formant masque (63) ayant une seconde fenêtre adaptée à ladite zone;

(c-1-3) attaquer sélectivement ladite partie de ladite surface majeure dudit corps semi-conducteur à travers ladite seconde fenêtre; et

(c-1-4) éliminer ledit second motif de masque (63).

## FIG. 1

## FIG.2A

## FIG.2B

## FIG. 3A

## FIG. 3B

## F I G . 3C

## F I G . 3D

17

## FIG. 3E

## FIG. 3F

FIG.4A

FIG.4B

## FIG. 5

## FIG. 6

*FIG.7*

*FIG.8A*

*FIG.8B*

FIG. 9

## FIG. 10

## FIG. 13

F I G . 1 1

W

Wa

132

134

131

136

133

135

112a

112b

112

112c

Da

Db

113

F I G . 1 2

112b

134

131

141

112c

140

112

113